# EUROPÄISCHE PATENTSCHRIFT

(11) **EP 3 408 921 B1**
(45) Veröffentlichungstag und Bekanntmachung des Hinweises auf die Patenterteilung: **23.10.2019**
(21) Anmeldenummer: 17723965.4
(22) Anmeldetag: 05.05.2017
(51) Int. Cl.: H02J 7/34, H02J 7/00, H02J 9/00

(54) **BESTIMMUNG DER KAPAZITÄT EINES ENERGIESPEICHERS EINER UNTERBRECHUNGSFREIEN GLEICHSTROMVERSORGUNGSEINHEIT**
DETERMINING THE CAPACITANCE OF AN ENERGY STORE OF AN UNINTERRUPTIBLE DIRECT CURRENT SUPPLY UNIT
DÉTERMINATION DE LA CAPACITÉ D'UN ACCUMULATEUR D'ÉNERGIE D'UNE UNITÉ D'ALIMENTATION EN COURANT CONTINU SANS INTERRUPTION

(30) Priorität: 12.05.2016 DE 102016208194
(43) Veröffentlichungstag der Anmeldung: 05.12.2018
(73) Patentinhaber: Siemens Aktiengesellschaft, 80333 München (DE)
(72) Erfinder: AUGESKY, Christian, 1100 Wien (AT)
(74) Vertreter: Maier, Daniel Oliver
(86) Internationale Anmeldenummer: PCT/EP2017/060742
(87) Internationale Veröffentlichungsnummer: WO 2017/194396

(56) Entgegenhaltungen:
- US-A- 5 894 222

## Beschreibung

### Technisches Gebiet

Die Erfindung betrifft ein Verfahren zur Bestimmung der Kapazität eines Energiespeichers einer Gleichstromversorgungseinheit zur unterbrechungsfreien Versorgung einer Last mit Gleichstrom, wobei die Gleichstromversorgungseinheit zumindest
- einen Eingang für eine Eingangsspannung,
- einen Ausgang für eine Ausgangsgleichspannung, aus dem eine an den Ausgang angeschlossene Last einen Laststrom beziehen kann,
- zwei gleichartige Energiespeicher, die über den Eingang mit einem Ladestrom geladen werden und im Pufferbetrieb eine Ersatz-Ausgangsgleichspannung zur Verfügung stellen, umfasst. Die Erfindung umfasst auch ein entsprechendes Computerprogrammprodukt sowie eine entsprechende Gleichstromversorgungseinheit.

Die Eingangsspannung kann sowohl eine Wechselspannung als auch eine Gleichspannung sein. Im Normalbetrieb stellt die Gleichstromversorgungseinheit die Ausgangsgleichspannung durch Wandlung einer Eingangsgleichspannung oder durch Gleichrichtung einer Eingangswechselspannung zur Verfügung. Wenn keine oder keine ausreichend hohe Eingangsspannung zur Verfügung steht, wechselt die Gleichstromversorgungseinheit in den Pufferbetrieb, während dessen die Ausgangsgleichspannung vom Energiespeicher, wie einem Akkumulator oder einer Batterie, zur Verfügung gestellt wird.

### Stand der Technik

Eine unterbrechungsfreie Stromversorgungseinheit versorgt eine am Ausgang angeschlossene Last auch während eines Einbruchs der Versorgungsspannung, die hier als Eingangsspannung bezeichnet wird. Neben der Last ist auch zumindest ein Energiespeicher, wie ein Akkumulator, der unterbrechungsfreien Stromversorgungseinheit an die Eingangsspannung angeschlossen. Diese Energiespeicher werden während des Normalbetriebs geladen und nach einem Einbruch der Versorgungsspannung im Pufferbetrieb als Energielieferant verwendet.

Zur Beurteilung der Leistungsfähigkeit und der noch zu erwartenden Lebensdauer bzw. Verwendbarkeit von Akkumulatoren ist die sichere Bestimmung der verfügbaren Akkukapazität und Spannungslage durch Entladen bei definierten Messbedingungen eine Grundvoraussetzung. Wird eine solche Messung während des Betriebs der Stromversorgungseinheit vorgenommen, ist die Stromversorgungseinheit für die Zeitdauer der Messung nicht für den Pufferbetrieb bereit, sodass es bei Netzstörungen zum Ausfall der Stromversorgung kommt.

Oft wird daher auf eine Kapazitätsmessung durch Entladen bis zum Entlade-Spannungsgrenzwert verzichtet und versucht, die Kapazität des Akkumulators durch eine kurzzeitige teilweise Entladung aus dem Verlauf der Akkumulatorspannung und abgespeicherten Referenzwerten zu ermitteln. Hier ist die Stromversorgungseinheit prinzipiell weiter verfügbar, die Aussagekraft über die Kapazität des Akkumulators jedoch gering.

Wenn tatsächlich ein Pufferbetrieb mit Entladung bis zum Entlade-Spannungsgrenzwert auftritt, kann hier durch Auswertung der während des Pufferbetriebs gewonnenen Messwerte eine Aussage über die Kapazität und die noch zu erwartende Lebensdauer des Akkumulators abgeleitet werden. Da ein tatsächlicher Pufferbetrieb jedoch selten auftritt und dann auch nicht zwingend eine vollständige Entladung bis zum Entlade-Spannungsgrenzwert auftritt, ist diese Art der Auswertung nicht für eine kontinuierliche Überwachung des Akkumulators und eine rechtzeitige Warnung vor dessen bevorstehenden Ausfall geeignet.

Es ist auch möglich, die Kapazität und Lebensdauer eines Akkumulators anhand eines detaillierten Modells des Akkumulators und unter Einbeziehung aller Umweltgrößen, der Belastungsfälle und der mitgemessenen Lebensdauer des realen Akkumulators zu berechnen, doch ist auch dies mit einer großen Ungenauigkeit behaftet.

Letztlich gibt nur eine vollständige Entladung des Akkumulators unter definierten Bedingungen eine gute Basis für die Bestimmung der Kapazität und der Lebensdauer eines Akkumulators.

Aus der Schrift US 5 894 222 A ist ein Verfahren zum individuellen Testen von Akkumulatorbatterien in einer unterbrechungsfreien Stromversorgung bekannt, bei welchem die Akkumulatorbatterien geladen und entladen werden, um die Zeitdauer zu reduzieren, während der die elektrische Kapazität der Akkumulatorbatterien kontinuierlich sinkt bzw. um den so genannten "Memory-Effekt" zu verhindern. Dazu wird jeweils eine zu testende Akkumulatorbatterie zuerst über ein Last entladen, wobei aus dem Verhältnis von Entladedauer und Spannung, welche an einer Last beim Entladen abfällt, eine Entladecharakteristik der jeweiligen Akkumulatorbatterie ermittelt wird. Während eine Akkumulatorbatterie mittels Entladen über die Last getestet wird, sind die anderen Akkumulatorbatterie meist vollständig aufgeladen und für einen Pufferbetrieb einsatzbereit.

### Darstellung der Erfindung

Es ist daher eine Aufgabe der vorliegenden Erfindung, ein Verfahren anzugeben, mit welchem die tatsächliche momentane Kapazität eines Energiespeichers einer Gleichstromversorgungseinheit bestimmt werden kann, aber gleichzeitig trotzdem ein Pufferbetrieb möglich ist, und welches eine verbesserte und flexibel einsetzbare Alternative zum Stand der Technik darstellt.

Diese Aufgabe wird durch ein Verfahren mit den Merkmalen des Patentanspruchs 1 gelöst, nämlich durch ein Verfahren zur Bestimmung der Kapazität eines Energiespeichers einer Gleichstromversorgungseinheit zur unterbrechungsfreien Versorgung einer Last mit Gleichstrom, wobei die Gleichstromversorgungseinheit zumindest
- einen Eingang für eine Eingangsspannung,
- einen Ausgang für eine Ausgangsgleichspannung, aus dem eine an den Ausgang angeschlossene Last einen Laststrom beziehen kann,
- zwei gleichartige Energiespeicher, die über den Eingang mit einem Ladestrom geladen werden und im Pufferbetrieb eine Ersatz-Ausgangsgleichspannung zur Verfügung stellen, umfasst.

Dabei ist vorgesehen, dass die Kapazität jedes der beiden Energiespeicher so dimensioniert ist, dass er allein den Pufferbetrieb bestreiten kann,
dass in vorgegebenen Zeitabständen in einem ersten Schritt ein geladener erster Energiespeicher vollständig über eine am Ausgang anliegende Last entladen wird,
dass in einem zweiten Schritt der erste Energiespeicher aus dem vollständig geladenen zweiten Energiespeicher geladen wird, und
dass in einem dritten Schritt der zweite Energiespeicher über den Eingang erneut vollständig geladen wird,
wobei im zweiten Schritt die aus dem zweiten Energiespeicher entnommene Kapazität gemessen wird und/oder im dritten Schritt die in den zweiten Energiespeicher geladene Kapazität gemessen wird.

Die erfindungsgemäße Lösung setzt zwei gleichartige Energiespeicher, insbesondere Akkumulatoren, für die unterbrechungsfreie Gleichstromversorgungseinheit voraus, also z.B. zwei identische Produkte. Sie sollten aber zumindest die gleiche Kapazität aufweisen. Insofern kann jeder der beiden Energiespeicher "erster Energiespeicher" oder "zweiter Energiespeicher" sein.

In Normalbetrieb sind die beiden Energiespeicher zu 100% geladen und pufferbereit, es steht also die doppelte benötigte Kapazität für den Pufferbetrieb zur Verfügung. Während des erfindungsgemäßen Verfahrens steht in Summe zumindest immer die Kapazität eines Energiespeichers zur Verfügung. Sollte es also zu einem Netzausfall kommen, so ist immer die Kapazität eines Energiespeichers für den Pufferbetrieb vorhanden. Im ersten Schritt steht der vollständig geladene zweite Energiespeicher zur Verfügung, im zweiten Schritt der teilweise geladene erste und der teilweise geladene zweite Energiespeicher und im dritten Schritt der vollständig geladene erste Energiespeicher.

Dadurch, dass beim erfindungsgemäßen Verfahren immer zumindest einer der Energiespeicher, unter kontrollierten Bedingungen und ohne Last, vollständig entladen wird und anschließend wieder unter kontrollierten Bedingungen vollständig geladen wird, kann man die Messdaten aus dem Entlade- und/oder dem Ladevorgang verwenden, um zumindest die tatsächliche Kapazität zu berechnen. Unter kontrollierten Bedingungen versteht man einen konstanten, vordefinierten Strom, für den reproduzierbare, vergleichbare Werte für die gespeicherte Kapazität ermittelt werden können.

Die im zweiten Schritt unter kontrollierten Bedingungen ermittelte entnommene Kapazität bildet den wesentlichen Indikator für die Leistungsfähigkeit des Akkumulators und die noch zu erwartende Lebenserwartung (üblicherweise wird das Ende der Lebensdauer des Akkumulators mit dem Sinken auf 80% der Anfangskapazität definiert).

Weiters kann der Quotient aus entladener zu geladener Kapazität gebildet werden, dies ergibt den Ladewirkungsgrad, der eine zusätzliche Indikation zur Leistungsfähigkeit des Akkumulators darstellt.

Es wäre auch denkbar, dass im ersten Schritt beim Entladen des ersten Energiespeichers über die Last die Kapazität des ersten Energiespeichers aufgrund von Messungen beim Entladen bestimmt wird, auch wenn dies nicht so genau ist wie im zweiten oder dritten Schritt, weil der Entladestrom von den gerade herrschenden Lastbedingungen im Stromversorgungssystem abhängt.

Um gleichbleibende Bedingungen während des zweiten Schrittes zu haben, kann vorgesehen sein, dass im zweiten Schritt der erste Energiespeicher aus dem vollständig geladenen zweiten Energiespeicher bei konstantem Strom geladen wird.

Um kontrollierte Bedingungen während des dritten Schrittes zu haben, ist in der Regel vorgesehen, dass im dritten Schritt der zweite Energiespeicher über den Eingang mit konstantem Strom erneut vollständig geladen wird.

Neben der Kapazität kann im zweiten und dritten Schritt auch die Ersatz-Ausgangsgleichspannung, auch als Spannungslage bezeichnet, des zweiten Energiespeichers gemessen werden. Die Spannungslage wird zumindest im vollständig geladenen Zustand gemessen, kann aber auch während des Entlade- und Ladevorgangs bei unterschiedlichen Ladezuständen gemessen werden.

Wenn eine Einrichtung zur Messung der absoluten Lebensdauer der Energiespeicher vorgesehen ist, hat dies den Vorteil, dass man dadurch die bisherige Lebensdauer kennt und damit die zu erwartende Lebensdauer eines Energiespeichers bestimmen kann.

Diese kann etwa aus gemessener Kapazität, gemessener Ersatz-Ausgangsgleichspannung (also Spannungslage) und gemessener absoluter Lebensdauer zum Messzeitpunkt der Kapazität und auf Basis von Herstellerangaben zum Energiespeicher bestimmt werden. Dabei können auch weitere Betriebsbedingungen berücksichtigt werden, wie die Umgebungstemperatur und die bisherige(n) Entladetiefe(n) und Entladungshäufigkeit(en).

Damit man die Kapazität beider Energiespeicher genau kennt, kann vorgesehen sein, dass zu vorgegebenen Zeitabständen das erfindungsgemäße Verfahren abwechselnd einmal beginnend mit dem ersten und einmal beginnend mit dem zweiten Energiespeicher durchgeführt wird. So wird also im ersten Monat z.B. im ersten Schritt der erste Akkumulator über Last entladen und im zweiten und/oder dritten Schritt die Kapazität des zweiten Akkumulators bestimmt. Im darauffolgenden Monat wird dann im ersten Schritt der zweite Akkumulator über Last entladen, im zweiten Schritt aus dem ersten Akkumulator der zweite Akkumulator geladen und im dritten Schritt der erste Akkumulator wieder über den Eingang geladen, womit die Kapazität des ersten Akkumulators bestimmt wird. Im dritten Monat wird dann wieder die Kapazität des zweiten Akkumulators bestimmt, usw.

Es ist aber nicht ausgeschlossen, dass sowohl die Kapazität des ersten als auch des zweiten Energiespeichers direkt nacheinander bestimmt werden, das erfindungsgemäße Verfahren also zweimal hintereinander mit wechselnden Energiespeichern ausgeführt wird.

In der Regel wird der vorgegebene Zeitabstand, in welchem das erfindungsgemäße Verfahren wiederholt zumindest einmal ausgeführt wird, wählbar sein und insbesondere etwa einen Monat betragen. Das erfindungsgemäße Verfahren sollte nicht zu oft durchgeführt werden, um nicht alleine dadurch die Lebensdauer der Akkumulatoren zu sehr zu verkürzen. Der zeitliche Abstand zwischen zwei erfindungsgemäßen Verfahren darf aber auch nicht zu groß sein, da ja ein Akkumulator zwischenzeitlich am Ende seiner Nutzungsdauer angelangt sein könnte. Der zeitliche Abstand richtet sich nach der Akku-Technologie und den damit verbundenen maximal möglichen Entladezyklen. Ein Monat ist ein typischer Wert, der sowohl bei Blei-, als auch bei Lithiumakkumulatoren diese Anforderungen in etwa erfüllt.

Das erfindungsgemäße Verfahren wird in der Regel computergesteuert mit einem der Gleichstromversorgungseinheit zugeordneten Rechner ausgeführt werden. Dieser Rechner kann physisch ein Teil der Gleichstromversorgungseinheit sein, er kann jedoch auch von der der Gleichstromversorgungseinheit getrennt und mittels Datenverbindung mit dieser verbunden sein. Der Rechner kann auch weitere Steuerungs- und Regelungsaufgaben für die Gleichstromversorgungseinheit ausführen bzw. auch ein bestehender Rechner kann die zusätzlichen erfindungsgemäßen Aufgaben übernehmen.

Da das erfindungsgemäße Verfahren also in der Regel durch einen Rechner ausgeführt werden wird, betrifft die Erfindung auch ein Computerprogrammprodukt, welches ein Programm umfasst und direkt in einen Speicher eines Rechners der Gleichstromversorgungseinheit ladbar ist, mit Programm-Mitteln, um alle Schritte des erfindungsgemäßen Verfahrens auszuführen, wenn das Programm vom Rechner ausgeführt wird. Das Computerprogrammprodukt kann beispielsweise ein Datenträger sein, auf welchem ein entsprechendes Computerprogramm gespeichert ist, oder es kann ein Signal oder Datenstrom sein, der über eine Datenverbindung in den Rechner geladen werden kann.

Eine erfindungsgemäße Gleichstromversorgungseinheit zur unterbrechungsfreien Versorgung einer Last mit Gleichstrom, zur Durchführung des erfindungsgemäßen Verfahrens, umfasst zumindest
- einen Eingang für eine Eingangsspannung,
- einen Ausgang für eine Ausgangsgleichspannung, aus dem eine an den Ausgang angeschlossene Last einen Laststrom beziehen kann,
- zwei gleichartige Energiespeicher, die über den Eingang mit einem Ladestrom geladen werden können und im Pufferbetrieb eine Ersatz-Ausgangsgleichspannung zur Verfügung stellen können.

Diese Gleichstromversorgungseinheit ist dadurch gekennzeichnet, dass die Kapazität jedes der beiden Energiespeicher so dimensioniert ist, dass er allein den Pufferbetrieb bestreiten kann,
dass für den ersten und den zweiten Energiespeicher eine schaltbare Verbindung, etwa durch Relais, vorgesehen ist, über welche der erste Energiespeicher aus dem zweiten Energiespeicher geladen werden kann, und umgekehrt, und
dass für jeden Energiespeicher eine Vorrichtung zum Messen der Kapazität vorgesehen ist.

Die schaltbare Verbindung kann z.B. eines oder mehrere Relais umfassen. Die Vorrichtung zum Messen der Kapazität kann beispielsweise ein Strommessgerät und ein Zeitmessgerät umfassen. Durch Messung der Stromstärke über die Zeit beim Laden bzw. Entladen kann als Kapazität die Strommenge in Ah (Amperestunden) bzw. bei kleineren Akkus in mAh (Milliamperestunden) berechnet werden, die man einem vollgeladenen Energiespeicher unter bestimmten Randbedingungen entnehmen kann.

Die Gleichstromversorgungseinheit kann auch über eine Regeleinheit verfügen mit welcher der Ladestrom der Energiespeicher auf einen konstanten Wert geregelt werden kann, z.B. als Teil der Ladeschaltung.

Die erfindungsgemäße Gleichstromversorgungseinheit ist zu jedem Zeitpunkt betriebsbereit, auch während des erfindungsgemäßen Verfahren.

Die Messung der aktuell verfügbaren Kapazität der Akkumulatoren ist vollkommen unabhängig von den Lastverhältnissen, was bei einer Entladung in die Last nicht gegeben wäre.

Der Mehraufwand für die erfindungsgemäße Gleichstromversorgungseinheit beschränkt sich auf die Möglichkeit der Umschaltung der Ladeschaltung zwischen den beiden Akkumulatoren, etwa mittels Relais oder Halbleiterschaltern, eine Ergänzung an der Zuschalteinrichtung und die Möglichkeit der elektrischen Kontaktierung für einen zweiten Akkumulator.

Mit Einschränkungen in der Zuverlässigkeit lässt sich auch mit nur einem Akkumulator eine Messung der Kapazität dieses Akkumulators vornehmen, indem dieser in die Last entladen wird und aus dieser wieder geladen wird und indem beim Laden und/oder Entladen die Kapazität aus Messwerten bestimmt wird.

Bei hohen zu puffernden Strömen bzw. Leistungen sind in bestehenden unterbrechungsfreien Gleichstromversorgungseinheiten oft bereits mehrere gleichartige, parallel geschaltete Akkumulatoren vorhanden, um eine Schädigung der Akkumulatoren unter hoher Last zu vermeiden. In diesem Fall müsste nur die Kontaktierung der Akkumulatoren an der Stromversorgung geändert werden, sodass diese in Hinkunft einzeln an diesem Grundgerät angeschaltet werden und mit dem erfindungsgemäßen Verfahren geprüft werden können.

### Kurzbeschreibung der Figuren

Zur weiteren Erläuterung der Erfindung wird im nachfolgenden Teil der Beschreibung auf die Figuren Bezug genommen, aus denen weitere vorteilhafte Ausgestaltungen, Einzelheiten und Weiterbildungen der Erfindung zu entnehmen sind. Die Figuren sind beispielhaft zu verstehen und sollen den Erfindungscharakter zwar darlegen, ihn aber keinesfalls einengen oder gar abschließend wiedergeben. Es zeigen
- Fig. 1: eine Gleichstromversorgungseinheit beim Entladen eines ersten Akkumulators über eine Last,
- Fig. 2: die Gleichstromversorgungseinheit beim Entladen eines zweiten Akkumulators in den ersten Akkumulator,

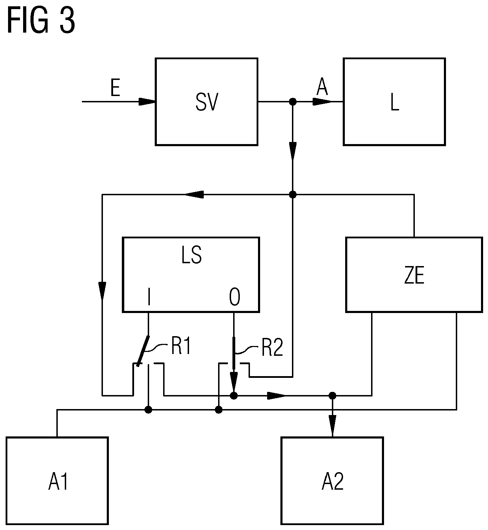

- Fig. 3: die Gleichstromversorgungseinheit beim Laden eines zweiten Akkumulators.

### Ausführung der Erfindung

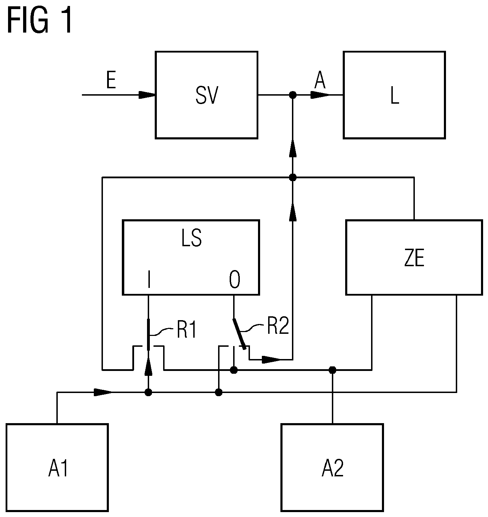

Fig. 1 zeigt schematisch eine erfindungsgemäße Gleichstromversorgungseinheit. Diese umfasst eine Stromversorgung SV, eine Ladeschaltung LS, zwei Energiespeicher, hier Akkumulatoren A1,A2, und eine Zuschalteinrichtung ZE. Die Stromversorgung SV stellt die Verbindung zum elektrischen Versorgungsnetz und zur Last L her und verfügt über einen Eingang E für eine Eingangsspannung. Über den Ausgang A der Gleichstromversorgungseinheit kann die Last L eine Ausgangsgleichspannung bzw. einen Laststrom beziehen.

Die Ladeschaltung LS verbindet die beiden Akkumulatoren A1,A2, mit der Stromversorgung SV und damit mit dem Eingang E. Über Relais R1,R2 können entweder der erste Akkumulator A1, oder der zweite Akkumulator R2 oder keiner der beiden Akkumulatoren an die Ladeschaltung LS angeschlossen und dadurch eben geladen oder nicht geladen werden. Die Zuschalteinrichtung ZE schaltet entweder den ersten Akkumulator A1, oder den zweiten Akkumulator A2, oder beide Akkumulatoren A1,A2 oder keinen der beiden Akkumulatoren an den Ausgang A und damit auf die Last L.

In der eingezeichneten Stellung der Relais R1,R2 ist der Akkumulator A1 an den Eingang I der Ladeschaltung LS geschaltet und der Ausgang O mit der Last L verbunden. Der Akkumulator A1 kann also in einem ersten Schritt vollständig über die Last L entladen werden. Möchte man stattdessen den Akkumulator A2 entladen, so wäre Relais R1 am Eingang I der Ladeschaltung LS nach rechts zu schalten. Beim Entladen über die Last könnte ebenfalls die Kapazität des jeweiligen Akkumulators A1,A2 aufgrund des gemessenen Stroms, der Ausgangsspannung, der Zeit, etc., bestimmt werden, allerdings mit geringerer Genauigkeit.

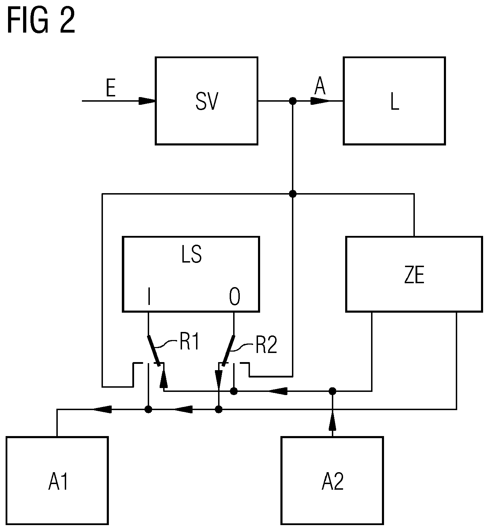

Ist der erste Akkumulator A1 vollständig entladen, so beginnt der zweite Schritt des erfindungsgemäßen Verfahrens, in welchem der erste Akkumulator A1 aus dem zweiten vollständig geladenen Akkumulator A2 geladen wird. In Fig. 2 sind in der eingezeichneten Stellung der Relais R1,R2 die beiden Akkumulatoren A1,A2 entsprechend miteinander verbunden. Der Akkumulator A2 wird über den Eingang I und den Ausgang O der Ladeschaltung LS vollständig in den Akkumulator A1 entladen. Die beiden Relais R1,R2 würden sich jeweils in der senkrechter Stellung befinden, sollte im anderen Fall der leere zweite Akkumulator A2 aus dem vollständig geladenen ersten Akkumulator A1 geladen werden.

Mit einem hier nicht dargestellten Strommessgerät, Spannungsmessgerät und einer Uhr können laufend der Entladestrom, die Spannungslage und die Zeit für die Entladung des zweiten Akkumulators A2 in den ersten Akkumulator A1 gemessen und daraus die Kapazität des zweiten Akkumulators A2 berechnet werden. Stehen Daten vom Hersteller des Akkumulators A2 über die Bestimmung der Lebensdauer des Akkumulators A2 zur Verfügung, so kann aus der bisherigen tatsächlichen Lebensdauer und den Messwerten bzw. der erfindungsgemäß bestimmten Kapazität die noch verbleibende Lebensdauer des Akkumulators A2 bestimmt werden.

Ist der Akkumulator A2 vollständig in den Akkumulator A1 entladen, wird der Akkumulator A2 über den Eingang E und die Stromversorgung SV erneut vollständig geladen. Mit einem hier nicht dargestellten Strommessgerät, Spannungsmessgerät und einer Uhr können dabei laufend der Ladestrom, die Spannungslage und die Zeit für die Ladung des zweiten Akkumulators A2 gemessen und daraus die Kapazität des zweiten Akkumulators A2 berechnet werden. Stehen Daten vom Hersteller des Akkumulators A2 über die Bestimmung der Lebensdauer des Akkumulators A2 zur Verfügung, so können aus der bisherigen tatsächlichen Lebensdauer und den Messwerten bzw. der erfindungsgemäß bestimmten Kapazität die noch verbleibende Lebensdauer des bestimmt werden.

Soll im umgekehrten Fall der leere erste Akkumulator A1 über den Eingang E geladen werden, muss das Relais R2 in die linke Stellung gebracht werden.

Nach der vorgegebenen Zeitdauer, z.B. einem Monat, wird das erfindungsgemäße Verfahren erneut, diesmal zur Bestimmung der Kapazität des ersten Akkumulators A1 durchgeführt. Dabei tauschen erster Akkumulators A1 und zweiter Akkumulators A2 die Rollen: es wird im ersten Schritt der zweite Akkumulator A2 über die Last L entladen, dann wird im zweiten Schritt der zweite Akkumulator A2 mit dem Inhalt des ersten Akkumulators A1 geladen und schließlich im dritten Schritt der erste Akkumulator A1 über den Eingang E erneut vollständig geladen. Beim zweiten und/oder beim dritten Schritt kann die Kapazität des ersten Akkumulators A1 gemessen werden.

### Bezugszeichenliste:

- A: Ausgang
- A1: erster Energiespeicher (erster Akkumulator)
- A2: zweiter Energiespeicher (zweiter Akkumulator)
- E: Eingang
- I: Eingang der Ladeschaltung LS
- L: Last
- LS: Ladeschaltung
- O: Ausgang der Ladeschaltung LS
- R1: erstes Relais
- R2: zweites Relais
- SV: Stromversorgung
- ZE: Zuschalteinrichtung

## Patentansprüche

1. Verfahren zur Bestimmung der Kapazität eines Energiespeichers (A1,A2) einer Gleichstromversorgungseinheit zur unterbrechungsfreien Versorgung einer Last (L) mit Gleichstrom, wobei die Gleichstromversorgungseinheit zumindest
- einen Eingang (E) für eine Eingangsspannung,
- einen Ausgang (A) für eine Ausgangsgleichspannung, aus dem eine an den Ausgang angeschlossene Last (L) einen Laststrom beziehen kann,
- zwei gleichartige Energiespeicher (A1,A2), die über den Eingang (E) mit einem Ladestrom geladen werden und im Pufferbetrieb eine Ersatz-Ausgangsgleichspannung zur Verfügung stellen, umfasst,
dass die Kapazität jedes der beiden Energiespeicher (A1,A2) so dimensioniert ist, dass er allein den Pufferbetrieb bestreiten kann,
dass in vorgegebenen Zeitabständen in einem ersten Schritt ein geladener erster Energiespeicher (A1) vollständig über eine am Ausgang (A) anliegende Last (L) entladen wird, **dadurch gekennzeichnet, dass** in einem zweiten Schritt der erste Energiespeicher (A1) aus dem vollständig geladenen zweiten Energiespeicher (A2) geladen wird, und
dass in einem dritten Schritt der zweite Energiespeicher (A2) über den Eingang (E) erneut vollständig geladen wird,
wobei im zweiten Schritt die aus dem zweiten Energiespeicher (A2) entnommene Kapazität gemessen wird und/oder im dritten Schritt die in den zweiten Energiespeicher (A2) geladene Kapazität gemessen wird.

2. Verfahren nach Anspruch 1, **dadurch gekennzeichnet, dass** im zweiten Schritt der erste Energiespeicher (A1) aus dem vollständig geladenen zweiten Energiespeicher (A2) bei konstantem Strom geladen wird.

3. Verfahren nach Anspruch 1 oder 2, **dadurch gekennzeichnet, dass** im dritten Schritt der zweite Energiespeicher (A2) über den Eingang (E) mit konstantem Strom erneut vollständig geladen wird.

4. Verfahren nach einem der Ansprüche 1 bis 3, **dadurch gekennzeichnet, dass** neben der Kapazität auch die Ersatz-Ausgangsgleichspannung des zweiten Energiespeichers (A2) gemessen wird.

5. Verfahren nach einem der vorhergehenden Ansprüche, **dadurch gekennzeichnet, dass** eine Einrichtung zur Messung der absoluten Lebensdauer der Energiespeicher (A1,A2) vorgesehen ist.

6. Verfahren nach einem der vorhergehenden Ansprüche, **dadurch gekennzeichnet, dass** aus gemessener Kapazität, gemessener Ersatz-Ausgangsgleichspannung und gemessener absoluter Lebensdauer zum Messzeitpunkt der Kapazität und auf Basis von Herstellerangaben zum Energiespeicher (A1,A2) eine zu erwartende Lebensdauer des Energiespeichers (A1,A2) bestimmt wird.

7. Verfahren nach einem der vorhergehenden Ansprüche, **dadurch gekennzeichnet, dass** zu vorgegebenen Zeitabständen das erfindungsgemäße Verfahren abwechselnd einmal beginnend mit dem ersten (A1) und einmal beginnend mit dem zweiten Energiespeicher (A2) durchgeführt wird.

8. Verfahren nach einem der vorhergehenden Ansprüche, **dadurch gekennzeichnet, dass** der vorgegebene Zeitabstand wählbar ist und insbesondere einen Monat beträgt.

9. Computerprogrammprodukt, welches ein Programm umfasst und direkt in einen Speicher eines Rechners der Gleichstromversorgungseinheit ladbar ist, mit Programm-Mitteln, um alle Schritte des Verfahrens nach einem der Ansprüche 1 bis 8 auszuführen, wenn das Programm vom Rechner ausgeführt wird.

10. Gleichstromversorgungseinheit zur unterbrechungsfreien Versorgung einer Last (L) mit Gleichstrom, konfiguriert zur Durchführung eines Verfahrens nach einem der Ansprüche 1 bis 8, wobei die Gleichstromversorgungseinheit zumindest
- einen Eingang (E) für eine Eingangsspannung,
- einen Ausgang (A) für eine Ausgangsgleichspannung, aus dem eine an den Ausgang angeschlossene Last (L) einen Laststrom beziehen kann,
- zwei gleichartige Energiespeicher (A1,A2), die über den Eingang (E) mit einem Ladestrom geladen werden können und im Pufferbetrieb eine Ersatz-Ausgangsgleichspannung zur Verfügung stellen können, umfasst, die Kapazität jedes der beiden Energiespeicher so dimensioniert ist, dass er allein den Pufferbetrieb bestreiten kann,
und für den ersten und den zweiten Energiespeicher (A1,A2) eine schaltbare Verbindung, etwa durch Relais (R1,R2) oder Halbleiterschalter, vorgesehen ist, über welche der erste Energiespeicher (A1) aus dem zweiten Energiespeicher (A2) geladen werden kann, und umgekehrt, und für jeden Energiespeicher (A1,A2) eine Vorrichtung zum Messen der Kapazität vorgesehen ist.

11. Gleichstromversorgungseinheit nach Anspruch 10, **dadurch gekennzeichnet, dass** eine Regeleinheit vorgesehen ist, mit welcher der Ladestrom der Energiespeicher (A1,A2) auf einen konstanten Wert geregelt werden kann.

## Claims

1. Method for determining the capacity of an energy store (A1, A2) of a DC power supply unit for the uninterruptible supply of direct current to a load (L), wherein the DC power supply unit comprises at least:
- an input (E) for an input voltage;
- an output (A) for a DC output voltage, from which output a load (L) connected to said output can draw a load current;
- two similar energy stores (A1, A2), which are charged by a charging current via the input (E), and in backup mode provide a replacement DC output voltage, the capacity of each of the two energy stores (A1, A2) is dimensioned for one energy store alone to be able to provide the backup mode,
in that in a first step, a charged first energy store (A1) is fully discharged at specified time intervals via a load (L) applied to the output (A), **characterised in that**
**in that** in a second step, the first energy store (A1) is charged from the fully charged second energy store (A2), and
**in that** in a third step, the second energy store (A2) is recharged fully via the input (E),
wherein in the second step, the capacity taken from the second energy store (A2) is measured, and/or in the third step, the capacity charged into the second energy store (A2) is measured.

2. Method according to claim 1, **characterised in that** in the second step, the first energy store (A1) is charged from the fully charged second energy store (A2) under constant current.

3. Method according to claim 1 or 2, **characterised in that** in the third step, the second energy store (A2) is recharged fully by constant current via the input (E).

4. Method according to one of claims 1 to 3, **characterised in that** the replacement DC output voltage of the second energy store (A2) is also measured in addition to the capacity.

5. Method according to one of the preceding claims, **characterised in that** a device is provided for measuring the absolute service life of the energy stores (A1, A2).

6. Method according to one of the preceding claims, **characterised in that** an expected service life of the energy store (A1, A2) is determined from measured capacity, measured replacement DC output voltage and measured absolute service life at the time of measuring the capacity, and on the basis of manufacturer data about the energy store (A1, A2).

7. Method according to one of the preceding claims, **characterised in that** the method according to the invention is performed at specified time intervals alternately, in one case starting with the first energy store (A1), and in one case starting with the second energy store (A2).

8. Method according to one of the preceding claims, **characterised in that** the specified time interval is selectable and in particular equals one month.

9. Computer program product which comprises a program and can be loaded directly into a memory of a processor of the DC power supply unit, and which has program means in order to perform all the steps of the method according to one of claims 1 to 8 when the program is executed by the processor.

10. DC power supply unit for the uninterruptible supply of direct current to a load (L) configured for performing a method according to one of claims 1 to 8, wherein the DC power supply unit comprises at least:
- an input (E) for an input voltage;
- an output (A) for a DC output voltage, from which output, a load (L) connected to said output can draw a load current;
- two similar energy stores (A1, A2), which can be charged by a charging current via the input (E), and in backup mode can provide a replacement DC output voltage, the capacity of each of the two energy stores is dimensioned for one energy store alone to be able to provide the backup mode,
the first energy store and the second energy store (A1, A2) are provided with a switchable connection, for instance by relays (R1, R2) or semiconductor switches, via which the first energy store (A1) can be charged from the second energy store (A2), and vice versa, and
each energy store (A1, A2) is provided with a device for measuring the capacity.

11. DC power supply unit according to claim 10, **characterised in that** a closed-loop control unit is provided which can be used to regulate the charging current of the energy stores (A1, A2) to a constant value.

## Revendications

1. Procédé de détermination de la capacité d'un accumulateur d'énergie (A1, A2) d'une unité d'alimentation en courant continu destinée à alimenter sans interruption une charge (L) avec du courant continu, dans lequel l'unité d'alimentation de courant continu comprend au moins :
- une entrée (E) pour une tension d'entrée,
- une sortie (A) pour une tension continue de sortie, à partir de laquelle une charge (L) connectée à la sortie peut percevoir un courant de charge, et
- deux accumulateurs d'énergie (A1, A2) similaires, qui sont chargés avec un courant de charge via l'entrée (E) et fournissent une tension continue de remplacement dans un fonctionnement en mode tampon,
la capacité de chacun des deux accumulateurs d'énergie (A1, A2) est dimensionnée de façon à ce qu'il puisse supporter seul le fonctionnement en mode tampon, et
à des intervalles de temps prédéterminés, dans une première étape, un premier accumulateur d'énergie chargé (A1) est déchargé complètement par une charge (L) appliquée à la sortie (A),
**caractérisé en ce que**, dans une seconde étape, le premier accumulateur d'énergie (A1) est chargé à partir du second accumulateur d'énergie (A2) entièrement chargé, et **en ce que**, dans une troisième étape, le second accumulateur d'énergie (A2) est rechargé complètement via l'entrée (E), dans lequel, dans la seconde étape, la capacité prélevée à partir du second accumulateur d'énergie (A2) est mesurée et/ou, dans la troisième étape, la capacité chargée dans le second accumulateur d'énergie (A2) est mesurée.

2. Procédé selon la revendication 1, **caractérisé en ce que**, dans la seconde étape, le premier accumulateur d'énergie (A1) est chargé avec un courant constant à partir du second accumulateur d'énergie (A2) complètement chargé.

3. Procédé selon la revendication 1 ou 2, **caractérisé en ce que**, dans la troisième étape, le second accumulateur d'énergie (A2) est rechargé complètement avec un courant constant via l'entrée (E).

4. Procédé selon l'une des revendications 1 à 3, **caractérisé en ce qu'**outre la capacité, la tension continue de sortie de remplacement du second accumulateur d'énergie (A2) est également mesurée.

5. Procédé selon l'une des revendications précédentes, **caractérisé en ce qu'**un équipement de mesure de la durée de vie absolue de l'accumulateur d'énergie (A1, A2) est prévu.

6. Procédé selon l'une des revendications précédentes, **caractérisé en ce qu'**une durée de vie attendue de l'accumulateur d'énergie (A1, A2) est déterminée à partir d'une capacité mesurée, d'une tension continue en sortie de remplacement mesurée et d'une durée de vie absolue mesurée à l'instant de mesure de la capacité et sur la base de données du fabricant de l'accumulateur d'énergie (A1, A2).

7. Procédé selon l'une des revendications précédentes, **caractérisé en ce que** le procédé selon l'invention est exécuté à des intervalles de temps prédéterminés, en alternant une fois commençant avec le premier accumulateur d'énergie (A1) et une fois commençant avec le second accumulateur d'énergie (A2).

8. Procédé selon l'une des revendications précédentes, **caractérisé en ce que** l'intervalle de temps prédéterminé peut être sélectionné et est notamment d'un mois.

9. Produit de programme informatique qui comprend un programme et peut être chargé directement dans une mémoire d'un ordinateur de l'unité d'alimentation de courant continu et comportant des moyens de programme pour exécuter toutes les étapes du procédé selon l'une des revendications 1 à 8 lorsque le programme est exécuté par l'ordinateur.

10. Unité d'alimentation de courant continu permettant d'alimenter sans interruption une charge (L) avec du courant continu, configurée pour exécuter un procédé selon l'une des revendications 1 à 8, dans laquelle l'unité d'alimentation de courant continu comprend au moins
- une entrée (E) pour une tension d'entrée,
- une sortie (A) pour une tension continue de sortie, à partir de laquelle une charge (L) connectée à la sortie peut percevoir un courant de charge, et
- deux accumulateurs d'énergie (A1, A2) similaires, qui peuvent être chargés avec un courant de charge via l'entrée (E) et peuvent fournir une tension continue de sortie de remplacement dans un fonctionnement en mode tampon,
dans laquelle la capacité de chacun des deux accumulateurs d'énergie (A1, A2) est dimensionnée de façon à ce qu'il puisse supporter seul le fonctionnement en mode tampon, et une connexion commutable, par exemple par un relais (R1, R2) ou un commutateur à semi-conducteur est prévue pour le premier et le second accumulateurs d'énergie (A1, A2), via laquelle le premier accumulateur d'énergie (A1) peut être chargé à partir du second accumulateur d'énergie (A2), et inversement, et
pour chaque accumulateur d'énergie (A1, A2), un dispositif de mesure de la capacité est prévu.

11. Unité d'alimentation de courant continu selon la revendication 10, **caractérisé en ce qu'**une unité de réglage est prévue, avec laquelle le courant de charge de l'accumulateur d'énergie (A1, A2) peut être réglé à une valeur constante.
